(19) Europäisches Patentamt
European Patent Office
Office européen des brevets

(11) **EP 3 435 151 A1**

(12) **EUROPEAN PATENT APPLICATION**
published in accordance with Art. 153(4) EPC

(43) Date of publication:
**30.01.2019 Bulletin 2019/05**

(51) Int Cl.:
***G02F 1/19*** *(2019.01)*

(21) Application number: **17770325.3**

(22) Date of filing: **23.03.2017**

(86) International application number:
**PCT/JP2017/011643**

(87) International publication number:
**WO 2017/164285 (28.09.2017 Gazette 2017/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **25.03.2016 JP 2016062620**
**22.03.2017 JP 2017056183**

(71) Applicant: **Nitto Denko Corporation**
**Ibaraki-shi, Osaka 567-8680 (JP)**

(72) Inventors:
• **KATAGIRI, Masayoshi**
**Ibaraki-shi**
**Osaka 567-8680 (JP)**

• **FUJINO, Nozomi**
**Ibaraki-shi**
**Osaka 567-8680 (JP)**
• **NASHIKI, Tomotake**
**Ibaraki-shi**
**Osaka 567-8680 (JP)**
• **WATANABE, Kenta**
**Ibaraki-shi**
**Osaka 567-8680 (JP)**

(74) Representative: **Grünecker Patent- und Rechtsanwälte**
**PartG mbB**
**Leopoldstraße 4**
**80802 München (DE)**

(54) **PROCESS FOR PRODUCING LIGHT-MODULATING FILM**

(57) A hydrogen-activation-type light-modulation film (1) includes a light-modulation layer (30) and a catalyst layer (40) on a polymer film substrate (10), and switches between a transparent state and a reflective state by hydrogenation and dehydrogenation. The light-modulation layer which reversibly changes in state between a transparent state by hydrogenation and a reflective state by dehydrogenation, and the catalyst layer which promotes hydrogenation and dehydrogenation in the light-modulation layer are deposited on a polymer film substrate by roll-to-roll sputtering. A process ranging from deposition of the light-modulation layer to deposition of the catalyst layer is continuously carried out without exposure to the air atmosphere.

FIG. 1

## Description

TECHNICAL FIELD

The present invention relates to a method for manufacturing a light-modulation film which includes a hydrogen-activation-type light-modulation layer and a catalyst layer on a transparent film substrate.

BACKGROUND ART

Light-modulation elements are used for window panes of buildings and vehicles, interior materials, and the like. Particularly in recent years, demand and expectation for light-modulation elements have been increased from the viewpoints of reducing a cooling and heating load, reducing a lighting load, improving comfort, and so on. Among light-modulation elements, a hydrogen-activation-type light-modulation element that switches between transmission and reflection of light by hydrogenation and dehydrogenation of a light-modulation material has an advantage that light from outside can be reflected to prevent inflow of heat, and therefore excellent heat shielding property is exhibited, so that a high energy saving effect is obtained. In addition, an area of the hydrogen-activation-type light-modulation element is readily increased, since it is able to switch between hydrogenation and dehydrogenation by a gas chromic system.

As hydrogen-activation-type light-modulation materials capable of reversibly switching between a transparent state and a reflective state by hydrogenation and dehydrogenation, rare earth metals such as yttrium, lanthanum and gadolinium, alloys of a rare earth metal and magnesium, alloys of an alkaline earth metals such as calcium, strontium or barium and magnesium, and alloys of a transition metal such as nickel, manganese, cobalt or iron and magnesium are known. Particularly, when a magnesium alloy is used as the light-modulation material, a light-modulation element having a high light transmittance in a transparent state is obtained because magnesium hydride has a visible light transmittance. In a hydrogen-activation-type light-modulation element, a catalyst layer is disposed in proximity to a light-modulation layer composed of a light-modulation material. The catalyst layer has a function of promoting hydrogenation and dehydrogenation of the light-modulation layer. As the catalyst layer, palladium, platinum, a palladium alloy, a platinum alloy or the like is used.

Patent Document 1 discloses a light-modulation element including a light-modulation layer and a catalyst layer on a glass substrate. Patent Document 2 suggests disposing a buffer layer such as a metal thin-film or a hydrogenated metal thin-film between a light-modulation layer and a catalyst layer for suppressing migration of magnesium to the catalyst layer, thereby suppressing deterioration of a light-modulation element when switching between hydrogenation and dehydrogenation is repeated.

PRIOR ART DOCUMENTS

PATENT DOCUMENTS

Patent Document 1: JP A 2013-83911
Patent Document 2: JP A 2014-26262

SUMMARY OF THE INVENTION

PROBLEMS TO BE SOLVED BY THE INVENTION

It may be useful to continuously deposit a functional layer such as a light-modulation layer or a catalyst layer by roll-to-roll sputtering with a film used in place of glass as a substrate for attaining mass production and cost reduction of a hydrogen-activation-type light-modulation element. In roll-to-roll sputtering, the inside of a sputtering apparatus is loaded with a roll body of a long film (*e.g.,* about 10 m to 100,000 m), film is unwound from the roll body and conveyed, and a layer is continuously deposited thereon. Therefore, a light-modulation film including a thin-film with a uniform thickness and uniform characteristics can be provided with a large length, and it is easy to increase an area. In addition, when a film substrate is used, the film is easily bonded to general glass or the like, and applicable to a curved surface, resulting in excellent versatility.

However, an example of forming a hydrogen-activation-type light-modulation element on a film substrate by roll-to-roll sputtering has not been heretofore reported, and problems in manufacturing, etc. are not evident. The present inventors attempted to prepare a light-modulation film including a hydrogen-activation-type light-modulation layer on a film substrate, and resultantly found that the light-modulation film had lower light-modulation performance as compared to a light-modulation element including a light-modulation layer and a catalyst layer on a glass substrate, or did not exhibit light-modulation performance. In view of such a problem, an object of the present invention is to provide a hydrogen-activation-type light-modulation film including a light-modulation layer and a catalyst layer on a film substrate and having light-modulation performance comparable to light-modulation performance obtained when a glass substrate is used.

MEANS FOR SOLVING THE PROBLEMS

The present inventors have conducted studies on a method for manufacturing a light-modulation film including a light-modulation layer and a catalyst layer on a film substrate, and resultantly found that when a light-modulation layer is deposited, and a catalyst layer is then deposited on the light-modulation layer without exposure to the air atmosphere, oxidation of the surface of the light-modulation layer is suppressed, so that a light-modulation film usable as a hydrogen-activation-type light-modulation element is obtained.

The present invention relates to a method for manufacturing a light-modulation film including a light-modulation layer and a catalyst layer in this order on a polymer film substrate. The light-modulation layer is a layer, the state of which reversibly changes between a transparent state by hydrogenation and a reflective state by dehydrogenation. The light-modulation layer is, for example, a thin film of a metal selected from the group consisting of a rare earth metal, an alloy of a rare earth metal and magnesium, an alloy of alkaline earth metal and magnesium, and an alloy of a transition metal and magnesium. The catalyst layer promotes hydrogenation and dehydrogenation in the light-modulation layer.

In the manufacturing method of the present invention, a light-modulation layer and a catalyst layer are deposited on a film substrate by roll-to-roll sputtering, and a process ranging from deposition of the light-modulation layer to deposition of the catalyst layer is continuously carried out without exposure to the air atmosphere. In one embodiment, a film substrate is unwound from an unwinding roll of a roll-to-roll sputtering apparatus, the film substrate is conveyed, and deposition of the light-modulation layer and deposition of the catalyst layer are carried out until the film substrate is wound around a winding roll. Thus, a process ranging from deposition of the light-modulation layer to deposition of the catalyst layer can be continuously carried out without bringing the sputtering deposition surface into contact with the film substrate. In the light-modulation layer, the oxygen content in a region within 5 nm from an interface on the catalyst layer side is preferably less than 50 atom%.

EFFECTS OF THE INVENTION

According to the manufacturing method of the present invention, oxidation of a light-modulation layer at an interface on the catalyst layer side is suppressed because a process ranging from deposition of the light-modulation layer to deposition of the catalyst layer is continuously carried out without exposure to the air atmosphere. Thus, a light-modulation film is obtained in which movement of hydrogen from the catalyst layer to the light-modulation layer is not hindered, and it is possible to switch between a transparent state and a reflective state by hydrogenation and dehydrogenation.

BRIEF DESCRIPTION OF THE DRAWINGS

FIG. 1 is a schematic sectional view showing stacking configuration example of a light-modulation film.
FIG. 2 is a block conceptual diagram of a sputtering deposition apparatus.
FIG. 3 is a block conceptual diagram of a sputtering deposition apparatus.
FIG. 4 is a block conceptual diagram of a sputtering deposition apparatus.
FIG. 5 is a schematic sectional view showing stacking configuration example of a light-modulation film.
FIG. 6 is a schematic sectional view showing stacking configuration example of a light-modulation film.

MODE FOR CARRYING OUT THE INVENTION

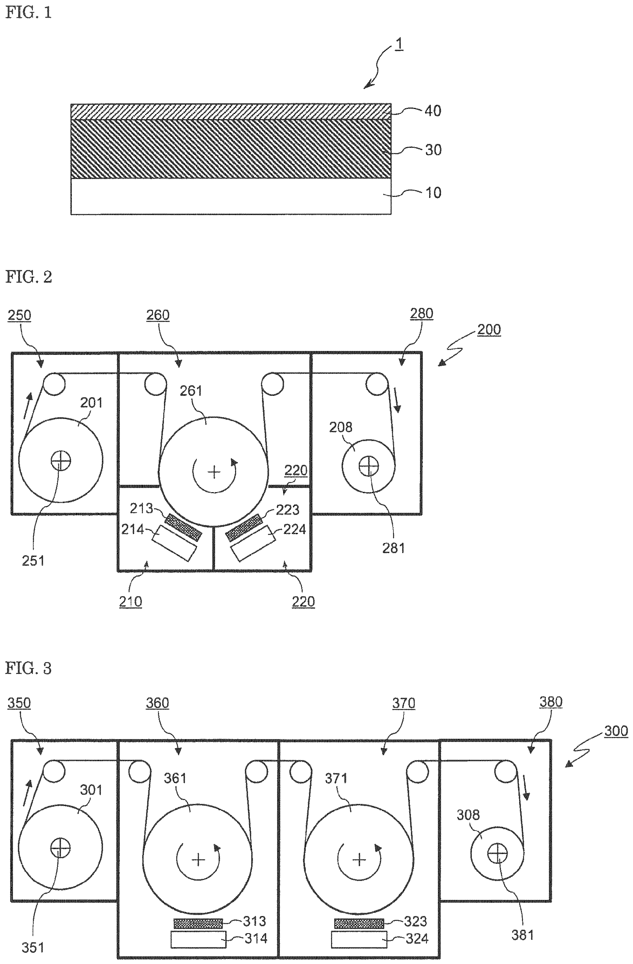

FIG. 1 is a schematic sectional view showing stacking configuration example of a light-modulation film according to the present invention. The light-modulation film 1 includes a light-modulation layer 30 and a catalyst layer 40 on a polymer film substrate 10.

The polymer film substrate 10 may be transparent or opaque. A transparent plastic material is preferably used as a material of the polymer film substrate for making the light-modulation film light-transmissive when the light-modulation layer is hydrogenated. Examples of the transparent plastic material include polyesters such as polyethylene terephthalate, polyolefins, cyclic polyolefins such as norbornene-based cyclic polyolefins, polycarbonate, polyether sulfone, and polyarylates.

The thickness of the polymer film substrate 10 is not particularly limited. The thickness of the polymer film is generally about 2 to 500 $\mu$m, and is preferably about 20 to 300 $\mu$m. A surface of the polymer film substrate 10 may be provided with an easily adhesive layer, an antistatic layer, a hard coat layer and the like. In addition, a surface of the polymer film substrate 10 may be subjected to an appropriate adhesion treatment such as a corona discharge treatment, an ultraviolet irradiation treatment, a plasma treatment, sputtering etching treatment or the like for improving adhesion with the light-modulation layer 30.

The heat shrinkage ratio of the polymer film substrate 10 in the longitudinal direction (MD: machine direction) is preferably 4% or less, more preferably 3% or less, further preferably 2% or less. When the polymer film substrate has a small heat shrinkage ratio, a dimensional change resulting from heating in a treatment during sputtering deposition and after deposition is small, so that stress at an interface between the polymer film substrate 10 and the light-modulation layer 30 can be reduced. Thus, warpage of the film due to stress at the interface and film delamination of the light-modulation layer can be suppressed to improve the durability of the light-modulation film. As described later, use of a film substrate having a small heat shrinkage ratio makes it hard to generate stress at an interface, so that warpage and film delamination of the light-modulation film can be suppressed even when the volume of the light-modulation layer changes due to absorption and desorption of hydrogen. The heat shrinkage ratio is a dimensional change ratio before and after heating at 180°C for 5 minutes, and is calculated in accordance with the following equation from the length L1 in MD before heating and the length L2 in MD after heating at 180°C for 5 minutes for a film cut out to 10 cm square.

$$\text{Heat shrinkage ratio (\%)} = \{(L1 - L2)/L1\} \times 100$$

The light-modulation film is obtained by sequentially depositing the light-modulation layer 30 and the catalyst layer 40 by a sputtering method on the polymer film substrate 10.

The material of the light-modulation layer 30 is not particularly limited as long as it contains a chromic material, the state of which is reversibly changed between a transparent state by hydrogenation and a reflective state by dehydrogenation. Specific examples of the material that constitutes the light-modulation layer include rare earth metals such as Y, La, Gd and Sm, alloys of a rare earth metal and magnesium, alloys of an alkaline earth metal such as Ca, Sr or Ba and magnesium, and alloys of a transition metal such as Ni, Mn, Co or Fe and magnesium. It is preferable that the light-modulation layer 30 contains magnesium for securing excellent transparency in hydrogenation state, and an alloy of a rare earth metal element and magnesium is more preferable from the viewpoint of securing both transparency and durability.

The light-modulation layer 30 may contain an element other than the above-mentioned alloy as a minor component.

The metal or alloy that constitutes the light-modulation layer 30 contains a metal element which is transformed into a transparent state by hydrogenation, and is transformed back into a reflective state by releasing hydrogen. For example, magnesium is transformed into transparent $MgH_2$ when hydrogenated, and is transformed back into Mg with a metallic reflection when dehydrogenated.

The catalyst layer 40 on the light-modulation layer 30 has a function of promoting hydrogenation and dehydrogenation of the light-modulation layer 30. The switching speed in switching from the reflective state to the transparent state (hydrogenation of the light-modulation layer) and switching from the transparent state to the reflective state (dehydrogenation of the light-modulation layer) is increased by disposing the catalyst layer 40.

The material of the catalyst layer 40 is not particularly limited as long as the catalyst layer 40 has a function of promoting hydrogenation and dehydrogenation of the light-modulation layer 30, and for example, it is preferable that catalyst layer 40 includes at least one metal selected from palladium, platinum, a palladium alloy and a platinum alloy. In particular, palladium is preferably used because it has high hydrogen permeability.

In the present invention, deposition on a long polymer film substrate travelling in a longitudinal direction is performed using a roll-to-roll sputtering apparatus. A process ranging from deposition of the light-modulation layer 30 to deposition of the catalyst layer 40 is continuously carried out without exposure to the air atmosphere, and thus the catalyst layer is deposited on the light-modulation layer without exposing the deposition surface of the light-modulation layer to the air atmosphere, so that oxidation of the light-modulation layer is suppressed.

The light-modulation layer and the catalyst layer are deposited using different sputtering targets. Generally, for replacing a target in a sputtering apparatus, it is necessary to break a vacuum in the apparatus to expose the film to the air atmosphere. In the manufacturing method of the present invention, it is preferable to use a roll-to-roll sputtering apparatus in which a plurality of targets can be mounted along a film conveyance direction for continuously depositing the light-modulation layer and the catalyst layer without exposure to the air atmosphere in the middle. As the roll-to-roll sputtering apparatus in which a plurality of targets can be mounted along the film conveyance direction, mention is made of one in which a plurality of targets can be disposed around one deposition roll; and one including a plurality of deposition rolls.

FIG. 2 is a block conceptual diagram of a roll-to-roll sputtering apparatus configured such that a plurality of targets can be disposed around one deposition roll. A sputtering apparatus 200 includes a preparation chamber 250, a deposition chamber 260 and a winding chamber 280, and a deposition roll 261 is arranged in the deposition chamber 260. In the deposition chamber 260, a plurality of sub-deposition chambers 210 and 220 separated by a partition wall are arranged along the circumferential direction of the deposition roll, and cathodes 214 and 224 are arranged in respective sub-deposition chambers. Targets 213 and 223 are disposed on the cathodes 214 and 224 so as to face the deposition roll 261. Although FIG. 2 shows an example in which two sub-deposition chambers are arranged around one deposition roll, three or more sub-deposition chambers may be arranged along the circumferential direction of the deposition roll.

In one embodiment of the method for manufacturing a light-modulation film using the sputtering apparatus shown in FIG. 2, a roll body 201 of a long film substrate is set on an unwinding roll 251 in the preparation chamber 250. The film substrate unwound from the unwinding roll is conveyed onto the deposition roll 261 in the deposition chamber 260, and guided to the first sub-deposition chamber 210 and the second sub-deposition chamber 220 in this order. A light-modulation layer is deposited on the film substrate in the first sub-deposition chamber 210, and a catalyst layer is deposited on the light-modulation layer in the second sub-deposition chamber 220. The light-modulation film in which the light-modulation layer and the catalyst layer are formed on the film substrate is guided to the winding chamber 280, and wound around the winding roll 281 to obtain a roll body 208 of the light-modulation film.

The sputtering apparatus 200 may be configured such that a film can be conveyed from the roll 281 side to the roll 251 side by reversing the driving direction of each roll. For example, it is also possible to set the roll body 201 of a film substrate on the roll 281, and deposit the light-modulation layer and the catalyst layer on the deposition roll 261 while conveying the film to the roll 251 side.

It is also possible to deposit the light-modulation layer on the deposition roll 261 while conveying a film from roll 251 side to the roll 281 side, wind up the film on the winding roll on a temporary basis, and then depositing the catalyst layer on the deposition roll 261 while conveying the film from the roll 281 side to the roll 251 side. When the light-modulation layer and the catalyst layer are deposited in two passes as described above, conditions for deposition of the light-modulation layer and conditions for deposition of the catalyst layer can be set separately, and therefore the degree of freedom of setting the deposition conditions is improved even when after deposition of the light-modulation layer, the catalyst layer is deposited without exposure to the air atmosphere. The substrate temperature during sputtering deposition by a roll-to-roll sputtering apparatus is a set temperature of the deposition roll. When the light-modulation layer and the catalyst layer are deposited on the same deposition roll in one-pass deposition, the substrate temperature during deposition of the light-modulation layer is the same as the substrate temperature during deposition of the catalyst layer, and in the case of two-pass deposition, the substrate temperature during deposition of the light-modulation layer and the substrate temperature during deposition of the catalyst layer can be set separately. When a plurality of targets are disposed in the apparatus beforehand, the light-modulation layer and the catalyst layer can be deposited on the film substrate without exposure to the air atmosphere in the middle even when deposition is performed in two passes, or three or more passes.

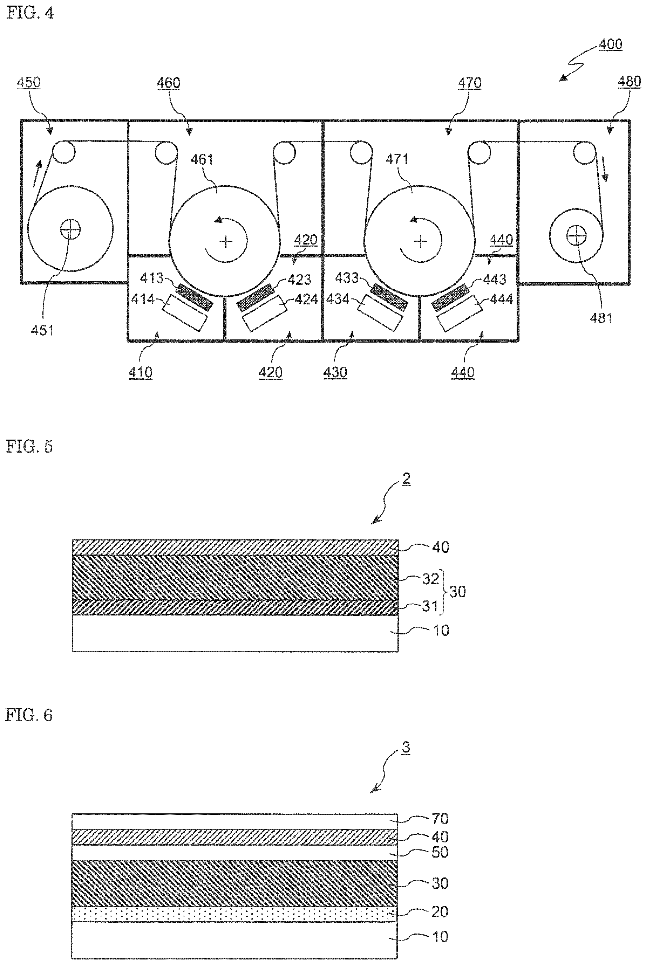

FIG. 3 is a block conceptual diagram of a roll-to-roll sputtering apparatus including a plurality of deposition rolls. A sputtering apparatus 300 includes two deposition chambers 360 and 370 between a preparation chamber 350 and a winding chamber 380, and deposition rolls 361 and 371 and cathodes 314 and 324 are arranged in the deposition chambers 360 and 370, respectively. Targets 313 and 323 are disposed on the cathodes 314 and 324 so as to face the deposition roll 361 and 371. Although FIG. 3 shows an example in which the sputtering apparatus includes two deposition rolls, the sputtering apparatus may include three or more deposition roll. As shown in FIG. 4, a plurality of sub-deposition chambers separated by partition walls are arranged around the deposition roll in each deposition chamber, and a cathode may be arranged in each sub-deposition chamber.

In one embodiment of a method for manufacturing a light-modulation film using the sputtering apparatus shown in FIG. 3, a film substrate unwound from an unwinding roll 351 in the preparation chamber 350 is conveyed onto the first deposition roll 361 in the first deposition chamber 360, a light-modulation layer is deposited on the film substrate, the film substrate is then conveyed onto the second deposition roll 371 in the second deposition chamber 370, and a catalyst layer is deposited on the light-modulation layer. The light-modulation film in which the light-modulation layer and the catalyst layer are formed on the film substrate is guided to the winding chamber 380, and wound around the winding roll 381 to obtain a roll body 308 of the light-modulation film. The sputtering apparatus 300 may be configured such that a film can be conveyed from the roll 381 side to the roll 351 side by reversing the driving direction of each roll.

When a sputtering apparatus including a plurality of deposition rolls as shown in FIG. 3 is used, the temperature of each deposition roll can be set separately. Thus, even when the light-modulation layer and the catalyst layer are deposited in one pass, the substrate temperature during deposition of the light-modulation layer and the substrate temperature during deposition of the catalyst layer can be set separately. Although the substrate temperature during deposition of the light-modulation layer and the catalyst layer is not particularly limited, the substrate temperature is preferably -20°C to 180°C from the viewpoint of suppressing embrittlement and thermal deformation of the film substrate.

FIG. 4 is a block conceptual diagram of a roll-to-roll sputtering apparatus which includes a plurality of deposition rolls, and is configured such that a plurality of targets can be disposed around one deposition roll. A sputtering apparatus 400 includes two deposition chambers 460 and 470, and deposition rolls 461 and 471 are arranged in the deposition chambers 460 and 470, respectively. In each of the deposition chambers 460 and 470, a plurality of sub-deposition chambers 410, 420, 430 and 440 separated by a partition wall are arranged along the circumferential direction of the deposition roll, and cathodes 414, 424, 434 and 444 are arranged in the respective sub-deposition chambers. Targets 413, 423, 433 and 443 are disposed on the respective cathodes so as to face the deposition rolls 461 and 471. In one mode of a method for manufacturing a light-modulation film using the sputtering apparatus shown in FIG. 4, a light-modulation layer and a catalyst layer are sequentially deposited in the first deposition chamber 460 and the second deposition chamber 470 while a film substrate is unwound from an unwinding roll 451 in a preparation chamber 450.

The light-modulation layer and the catalyst layer may be deposited in divided parts in the thickness direction using a plurality of cathodes. For example, when the sputtering apparatus in FIG. 4 is used, the light-modulation layer can be deposited in two divided parts in the thickness direction by disposing targets 413 and 423 for deposition of a light-modulation layer on two cathodes 414 and 424, respectively, in the first deposition chamber. A part of the light-modulation layer based on the thickness may be deposited in the first deposition chamber 460, followed by depositing the remaining part of the light-modulation layer based on the thickness and the catalyst layer in the second deposition chamber 470. In addition, the light-modulation layer and the catalyst layer may be deposited in one of the first deposition chamber and the second deposition chamber, and an underlayer and a surface layer may be deposited in the other deposition chamber. When three or more cathodes are disposed along one deposition roll, or a sputtering apparatus including three or more deposition rolls is used, variations in deposition can be further increased.

In deposition of the light-modulation layer and the catalyst layer by roll-to-roll sputtering, it is preferable that after the inside of the sputtering apparatus is loaded with a roll-shaped film substrate and before deposition is started, the inside of the sputtering apparatus is evacuated to remove moisture in the apparatus, and moisture, oxygen and impurities such as organic gases generated from the film substrate. By removing gases in the apparatus and in the film substrate beforehand, oxidation due to incorporation of oxygen, moisture and the like into the light-modulation layer 30 can be suppressed.

In roll-to-roll sputtering using a long film substrate, the inside of a vacuum chamber of the sputtering apparatus is loaded with a larger amount (volume) of the substrate as compared to sputtering onto glass or a sheet film, and therefore moisture and the like in the substrate tend to be hardly desorbed, leading to an increase in the amount of outgas from the substrate during sputtering deposition. Moisture and the like from the substrate may oxidize the light-modulation layer, resulting in deterioration of light-modulation performance. Thus, in deposition of the light-modulation layer by roll-to-roll sputtering, it is preferable that the pressure of the inside of the sputtering apparatus before the start of sputtering deposition (before introduction of a process gas) is as low as possible (ultimate vacuum is as high as possible). The pressure of the inside of the apparatus before the start of sputtering deposition is, for example, $1 \times 10^{-2}$ Pa or less, preferably $5 \times 10^{-3}$ Pa or less, more preferably $1 \times 10^{-3}$ Pa or less, further preferably $5 \times 10^{-4}$ Pa or less, particularly preferably $5 \times 10^{-5}$ Pa or less. After the inside of the sputtering apparatus is decompressed, the long film substrate may be conveyed in the vacuum chamber to desorb moisture and the like in the film substrate before the start of sputtering deposition.

<Deposition of light-modulation layer >

A metal target is used for deposition of the light-modulation layer 30 on the inorganic metal oxide layer 20. When an alloy layer is deposited as the light-modulation layer, an alloy target may be used, or a plurality of metal targets may be used. In addition, an alloy layer may also be formed using a target (split target) in which a plurality of metal plates are arranged and bonded on a backing plate in such a manner that an erosion portion has a predetermined area ratio. When a plurality of metal targets are used, an alloy layer having a desired composition can be formed by adjusting an electric power applied to each target. The light-modulation layer is deposited while an inert gas is introduced.

Since a metal oxide formed by sputtering easily forms a dense film, the oxidized region 31 formed in the initial stage of deposition of the light-modulation layer 30 has an effect of blocking outgas from the film substrate 10. In other words, since the oxidized region 31 of the light-modulation layer 30 at the interface with the film substrate 10 functions as a sacrificial layer, oxidation of the light-modulation region 32 situated on the catalyst layer 40 side can be suppressed to maintain high light-modulation performance. Thus, when the light-modulation layer is deposited so as to be in contact with the film substrate 10, it is preferable to form the light-modulation layer 30 having the oxidized region 31 with an oxygen content of 50 atom% or more on the film substrate 10 side, and a light-modulation region 32 with an oxygen content of less than 50 atom% on the oxidized region 31.

When the light-modulation layer 30 has the oxidized region 31 on the interface side with the film substrate 10, the thickness thereof is not particularly limited. For ensuring that the oxidized region is a continuous film, the thickness of the oxidized region 31 is preferably 2 nm or more. On the other hand, when the thickness of the oxidized region is excessively large, productivity and light-modulation performance tend to be deteriorated, and therefore the thickness of the oxidized region is preferably 100 nm or less. When the light-modulation layer 30 is deposited so as to be in contact with the film substrate 10, the thickness of the oxidized region is more preferably from 4 to 80 nm, further preferably from 6 to 60 nm. The thickness of the oxidized region formed in the initial stage of deposition can be controlled by adjusting the substrate temperature, the gas introduction amount, the process pressure, the metal composition of the target, and the like during deposition of the light-modulation layer.

It is preferable that the oxygen content in the vicinity of an interface of the light-modulation layer 30 on the catalyst layer 40 side is as small as possible. Specifically, the oxygen content within a range of 5 nm from an interface of the light-modulation layer 30 on the catalyst layer 40 side is preferably less than 50 atom%, more preferably 45 atom% or less, further preferably 40 atom% or less. When the oxygen content at an interface of the light-modulation layer 30 on the catalyst layer 40 side is in the above-mentioned range, movement of hydrogen between the catalyst layer 40 and the light-modulation layer 30 is promoted, so that a light-modulation film having favorable light-modulation performance is obtained. In addition, as the oxygen content at an interface of the light-modulation layer 30 on the catalyst layer 40 side decreases, deterioration of the element due to repetition of switching is reduced, so that a light-modulation film excellent in durability in long-term use is obtained.

The oxygen content in the light-modulation layer 30 is determined by measuring a thickness-direction distribution (depth profile) of an element concentration by X-ray electron spectroscopy (XPS) while etching the light-modulation layer from the surface side (catalyst layer 40 side) toward the substrate side of the light-modulation film. The etching depth (nm) in the depth profile is calculated by multiplying an etching time (min) by a standard etching rate (nm/min) for $SiO_2$. In the resulting depth profile, a position which is situated between a layer adjacent to the light-modulation layer and the light-modulation layer and at which the concentration of an element contained in the largest amount in the layer adjacent to the light-modulation layer is a half value of the maximum value is defined as an interface between the light-modulation layer and the adjacent layer (start point and end point of the light-modulation layer). The distance between the start point of the light-modulation layer and a point at which the oxygen content is 50 atom% or more is defined as a thickness of the light-modulation region 32, and the thickness of a region where the oxygen content is 50 atom% or more is defined as a thickness of the oxidized region 31.

Although the thickness of the light-modulation layer 30 is not particularly limited, it is preferably 10 nm to 500 nm, more preferably 15 nm to 200 nm, further preferably 20 nm to 100 nm for securing both the light transmittance in the transparent state and the light shielding ratio (reflectance) in the reflective state. When the thickness of the light-modulation layer is excessively small, the light reflectance in the reflective state tends to decrease, and when the thickness of the light-modulation layer is excessively large, the light transmittance in the transparent state tends to decrease. When the oxidized region 31 having an oxygen content of 50 atom% or more is formed in the vicinity of an interface of the light-modulation layer 30 on the substrate 10 side as shown in FIG. 5, the thickness of the light-modulation region 32 having an oxygen content of less than 50 atom% is preferably 10 nm or more, more preferably 15 nm or more, further preferably 20 nm or more.

<Deposition of catalyst layer>

After deposition of the light-modulation layer, the catalyst layer is deposited without exposure to the air atmosphere. A metal target is used for deposition of the catalyst layer. The catalyst layer is deposited while an inert gas is introduced. The thickness of the catalyst layer can be appropriately set according to the reactivity of the light-modulation layer, the catalytic ability of the catalyst layer, and the like. Although it is not particularly limited, the thickness of the catalyst layer is preferably 1 to 30 nm, more preferably 2 to 20 nm. When the thickness of the catalyst layer is excessively small, the catalytic function for hydrogenation and dehydrogenation is not sufficiently exhibited in some cases, and when the thickness of the catalyst layer is excessively large, the light transmittance tends to decrease.

As described above, an oxidized region may be formed at an interface of the light-modulation layer 30 on the substrate 10 side. On the other hand, when an oxide film is formed at an interface of the light-modulation layer 30 on the catalyst layer 40 side, movement of hydrogen between the catalyst layer and the light-modulation layer is hindered by the oxide film. In particular, magnesium has high bonding strength with oxygen, and therefore when an interface, on the catalyst layer side, of a light-modulation layer containing magnesium as a main component is oxidized, the light-modulation layer is not hydrogenated even when hydrogen is introduced from the catalyst layer side, and thus light-modulation performance cannot be exhibited.

In the present invention, the catalyst layer is deposited without exposure to the air atmosphere after deposition of the light-modulation layer, and thus exposure of deposition surface of the light-modulation layer is prevented, so that oxidation of an interface on the light-modulation layer 30 on the catalyst layer 40 side can be suppressed. Thus, even when the light-modulation layer is composed of a material containing as a main component a metal having high bonding strength with oxygen, such as magnesium, the oxygen content in the vicinity of an interface of the light-modulation layer 30 on the catalyst layer 40 side can be made to fall within the above-mentioned range, and a light-modulation film capable of switching between a transparent state and a reflective state by hydrogenation and dehydrogenation of the light-modulation layer is obtained.

By using a roll-to-roll sputtering apparatus in which a plurality of targets can be arranged along the film conveyance direction, a process ranging from deposition of the light-modulation layer to deposition of the catalyst layer can be carried out without exposure to the air atmosphere as described above.

The film substrate provided with the light-modulation layer may be wound up on a temporary basis, followed by conveying the film again and depositing the catalyst layer; or the catalyst layer may be deposited after deposition of the light-modulation layer without winding up the film substrate, thereby depositing these layers in one pass. When deposition of the light-modulation layer and deposition of the catalyst layer are carried out on different deposition rolls using a sputtering apparatus including a plurality of deposition rolls as shown in FIGS. 3 and 4, the light-modulation layer and the catalyst layer can be deposited at different substrate temperatures in one pass.

Contact between the deposition surface of the light-modulation layer and the film substrate, as well as exposure of the deposition surface of the light-modulation layer, may cause an increase in oxygen content at an interface of the light-modulation layer on the catalyst layer side. In particular, when a film substrate composed of an oxygen atom-containing polymer such as polyester is used, or a film substrate in which an oxygen atom-containing hard coat layer of acrylic or epoxy is formed on a back surface (a surface opposite to the light-modulation layer forming surface) is used, the deposition surface may be easily oxidized by contact between the back surface of the film substrate and the deposition surface of the light-modulation layer. When the light-modulation layer and the catalyst layer are deposited in one pass, the catalyst layer is formed on the light-modulation layer without bringing the deposition surface of the light-modulation layer into contact with the back surface of the film substrate. In one-pass deposition, the time until the catalyst layer is deposited on the light-modulation layer after deposition of the light-modulation layer is short, so that oxidation of the light-modulation layer, which is caused by outgas etc. from the substrate in the sputtering apparatus, can be suppressed. Thus, when the light-modulation layer and the catalyst layer are deposited in one pass, further suppression of oxidation at an interface of the light-modulation layer on the catalyst layer side can be expected.

In roll-to-roll sputtering, the amount of outgas from the film substrate tends to be larger as compared to sputtering onto glass or a sheet film as described above, and when the light-modulation layer contains a metal having high bonding strength with oxygen, such as magnesium, the light-modulation layer deposited on the substrate may be oxidized by outgas (oxidizing gas) from the film substrate in a vacuum chamber even when the film is not exposed to the air atmosphere. Thus, it is preferable that a film having oxidation resistance higher than that of the light-modulation layer is deposited on the light-modulation layer in a short time after deposition of the light-modulation layer. Specific examples of the film having oxidation resistance higher than that of the light-modulation layer include the catalyst layer, and a buffer layer and surface layer as described later.

The time until deposition of a film having high oxidation resistance, such as the catalyst layer, on the light-modulation layer after deposition of the light-modulation layer is preferably 60 minutes or less, more preferably 45 minutes or less, further preferably 30 minutes or less, especially preferably 10 minutes or less. When the film substrate on which the light-modulation layer has been deposited is wound up on a temporary basis, followed by conveying the film again and depositing the catalyst layer, it is preferable the film conveyance is resumed in a short time after the film substrate is wound up. In addition, since the time until the catalyst layer is deposited after deposition of the light-modulation layer varies along the longitudinal direction of the film substrate, it is preferable to adjust the total length of the film substrate so that the time until deposition of the catalyst layer on a portion where the light-modulation layer is deposited first (the roll outer peripheral surface of the substrate at the start of deposition) is 60 minutes or less. On the other hand, when the light-modulation layer and the catalyst layer are deposited in one pass, the time until the catalyst layer is deposited after deposition of the light-modulation layer is uniform along the longitudinal direction of the film substrate, and therefore there is no limit to the total length of the film substrate, so that the productivity of the light-modulation film in the roll-to-roll process can be improved. Although the lower limit of the time until the catalyst layer or the like is deposited after deposition of the light-modulation layer is not particularly limited, it is generally 0.1 second or more.

The film substrate conveyance speed in deposition of the light-modulation layer and the catalyst layer by roll-to-roll sputtering is, for example, 0.5 m/minute or more, preferably 1 m/minute or more, more preferably 2 m/minute or more. By increasing the film substrate conveyance speed, the time until the catalyst layer is deposited on the light-modulation layer after deposition of the light-modulation layer can be reduced to suppress oxidation of the light-modulation layer, which is caused by outgas etc. from the film substrate in the vacuum chamber. The upper limit of the film substrate conveyance speed is not particularly limited as long as conveyance performance can be maintained, and the upper limit of the film substrate conveyance speed is generally 100 m/minute or less.

<Other additional layers>

The light-modulation film according to the present invention may include layers other than the light-modulation layer 30 and the catalyst layer 40 on the polymer film substrate 10. For example, as shown in FIG. 6, an underlayer 20 may be disposed between the film substrate 10 and the light-modulation layer 30, or a buffer layer 50 may be disposed between the light-modulation layer 30 and the catalyst layer 40. In addition, a surface layer 70 may be disposed on the catalyst layer.

(Underlayer)

When the underlayer 20 is disposed on the film substrate 10, oxidation of an interface of the light-modulation layer 30 on the film substrate 10 side during deposition may be suppressed. In particular, when an inorganic oxide layer is formed as the underlayer 20 on the film substrate 10, moisture, oxygen gas and the like, which are generated from the film substrate 10, can be blocked to suppress oxidation of the light-modulation layer 30.

As the inorganic oxide, oxides of metal or semimetal elements such as Si, Ge, Sn, Pb, Al, Ga, In, Tl, As, Sb, Bi, Se, Te, Mg, Ca, Sr, Ba, Sc, Y, Ti, Zr, Hf, V, Nb, Ta, Cr, Mo, W, Mn, Tc, Re, Fe, Ru, Os, Co, Rh, Ir, Ni, Pd, Pt, Cu, Ag, Au, Zn and Cd are preferably used. The inorganic oxide layer may contain a mixed oxide of plurality of (semi)metals. Among them, an oxide of Si, Nb, Ti or the like is preferable because it absorbs little light, and is excellent in gas barrier property against oxygen, water vapor and the like.

For imparting barrier property against a gas from the film substrate, the thickness of the underlayer 20 is preferably 1 nm or more. On the other hand, when the thickness of the underlayer is excessively large, the light transmittance tends to be reduced due to light absorption by an inorganic oxide, etc. which form the underlayer. Therefore, the thickness of the underlayer is preferably 200 nm or less. When the underlayer 20 has barrier property against a gas from the film substrate, formation of an oxidized region in the initial stage of deposition of the light-modulation layer is suppressed. In addition, when the oxidized region is not formed, or the thickness of the oxidized region is small, outgas from the film substrate 10 is blocked by the underlayer 20, and therefore oxidation of the light-modulation layer 30, which is caused by the outgas from the film substrate, can be suppressed to maintain high light-modulation performance.

When the underlayer is disposed between the film substrate and the light-modulation layer, a film substrate with the underlayer formed thereon beforehand may be used, or immediately after deposition of the light-modulation layer, the underlayer may be deposited by a sputtering method in the same pass as in deposition of the light-modulation layer. When an underlayer of an inorganic oxide is deposited by a sputtering method, a metal target or an oxide target is used. When a metal target is used, sputtering deposition is performed while in addition to an inert gas such as argon, a reactive gas (*e.g.,* oxygen) is introduced. When an oxide target is used, deposition is performed while an inert gas such as argon is introduced. When an oxide target is used, deposition may be performed while a reactive gas is introduced as necessary.

(Buffer layer)

When the buffer layer 50 is disposed between the light-modulation layer 30 and the catalyst layer 40, it is preferable the buffer layer 50 is permeable to hydrogen. The buffer layer may include only one layer, or a plurality of layers. For example, the buffer layer 50 may have a stacked structure of a layer having a function of suppressing migration of a metal from the light-modulation layer 30 and a layer suppressing passage of oxygen from the catalyst layer 40 side to the light-modulation layer 30.

When a metal thin-film consisting of Ti, Nb, V, an alloy of these metals, etc. is disposed as the buffer layer 50 between the light-modulation layer 30 and the catalyst layer 40, the switching speed from the transparent state to the reflective state in dehydrogenation tends to increase while migration of magnesium etc. from the light-modulation layer and the catalyst layer is suppressed.

When a metal thin-film including W, Ta, Hf, an alloy of these metals, etc. is disposed as the buffer layer 50, passage of oxygen to the light-modulation layer 30 from the catalyst layer 40 side can be suppressed to inhibit degradation of the light-modulation layer by oxidation. In addition, when a metal thin-film including a metallic material similar to that in the light-modulation layer is inserted as the buffer layer 50, the layer functions as a sacrificial layer which reacts with oxygen passing through the catalyst layer 40, so that oxidation of the light-modulation layer 30 can be suppressed. Preferably, the buffer layer acting as such a sacrificial layer is reversibly bonded with oxygen, and hydrogenated in hydrogenation of the light-modulation layer 30 (transparent state), so that the light transmittance increases. Thus, when a magnesium alloy is used for the buffer layer, the content of magnesium based on the total amount of metallic elements is preferably less than 50 atom%.

Formation of the buffer layer 50 on the light-modulation layer 30 is performed by roll-to-roll sputtering. In manufacturing of a light-modulation film including the buffer layer 50 between the light-modulation layer 30 and the catalyst layer 40, the buffer layer 50 and the catalyst layer 40 are continuously deposited without exposure to the air atmosphere after formation of the light-modulation layer 30. The thickness of the buffer layer 50 can be appropriately set according to its purpose and so on, and is not particularly limited. The thickness is, for example, 1 to 200 nm, and preferably 1 to 30 nm.

<Surface Layer>

When the surface layer 70 is disposed on the catalyst layer 40, the surface layer 70 may be permeable to hydrogen. Preferably, the surface layer 70 has a function of blocking passage of water and oxygen to prevent oxidation of the light-modulation layer 30. In addition, by adjusting the optical thickness of the surface layer 70, light reflection at a surface of the light-modulation film can be reduced to increase the light transmittance in the transparent state.

As a material of the surface layer 70, a (semi)metal oxide shown above as an example of the material for the inorganic oxide layer that composes the underlayer, a metal shown as an example as the material of the buffer layer, or the like can be used. As a material of the surface layer 70, an organic material such as a polymer, an organic-inorganic hybrid material, or the like may also be used. When a material having water repellency such as a fluorine-based resin is used for the surface layer 70, the function of suppressing oxidation of the light-modulation layer 30 by water or oxygen can be further enhanced to improve the durability of the light-modulation element.

The thickness of the surface layer 70 can be appropriately set according to its purpose and so on, and is not particularly limited. The thickness is, for example, about 1 nm to 50 $\mu$m. The surface layer may include only one layer, or a plurality of layers. For example, when a plurality of thin-films having different refractive indices are stacked, and the optical thickness of each layer is adjusted, antireflection property can be improved to increase the light transmittance in the transparent state. In addition, durability can also be improved by combining an organic layer and an inorganic layer.

The method for forming the surface layer 70 is not particularly limited. In continuation with deposition of the catalyst layer 40, the surface layer may be deposited by roll-to-roll sputtering, or the surface layer may be formed after exposure to the air atmosphere after formation of the catalyst layer. The method for forming the surface layer is not limited to a sputtering method. When the surface layer is formed of an organic material such as a polymer, or an organic-inorganic hybrid material, it is preferable that deposition is performed by a wet method such as spin coating, dip coating, gravure coating or die coating. When the surface layer is formed of an inorganic material, a wet method such as the above-mentioned coating method, CBD method, plating method, or the like may be employed, or a dry process other than sputtering method, such as a vacuum vapor deposition method, an electron beam vapor deposition method, a CVD method or the like can also be employed.

[Light-modulation element]

The light-modulation film of the present invention can be used for a hydrogen-activation-type light-modulation element capable of switching a light-transmissive state and a light-reflective state by hydrogenation and dehydrogenation of the light-modulation layer. The method for hydrogenating and dehydrogenating the light-modulation layer is not particularly limited. Examples thereof include a method in which the light-modulation film is exposed to a hydrogen atmosphere to hydrogenate the light-modulation layer, and the light-modulation film is exposed to an oxygen atmosphere (air) to dehydrate the light-modulation layer (gas chromic method); and a method in which the light-modulation layer 30 is hydrogenated and dehydrogenated using a liquid electrolyte (electrolytic solution) or a solid electrolyte (electrochromic method). Among them, the gas chromic method is preferable because it is possible to switch a light-modulation layer having a large area in a short time.

The light-modulation film of the present invention as it is may be used as a light-modulation element, or may be combined with a transparent member such as glass, a translucent member, an opaque member or the like to form a light-modulation element. A gasochromic-type light-modulation element can also be formed by disposing the light-modulation film according to the present invention in a gas-filling chamber. The gasochromic light-modulation element has, for example, a configuration in which gaps between a plurality of transparent members each serve as a gas-filling chamber, and a light-modulation film is disposed in the gas-filling chamber. In this light-modulation element, hydrogen is supplied into and exhausted from the gas-filling chamber to hydrogenate and dehydrogenate the light-modulation layer, so that it is possible to reversibly switch between a transparent state and a reflective state.

The volume of the light-modulation layer is changed by hydrogenation and dehydrogenation, resulting in generation of stress at the film interface. In a light-modulation film with a light-modulation layer formed on a flexible film substrate, stress at a film interface of the light-modulation layer on the film substrate side may cause warpage or delamination of the film. In the present invention, a film substrate having a low heat shrinkage ratio is used, and thus even when a volume change occurs due to absorption and desorption of hydrogen by the light-modulation layer, stress at the interface is relaxed, so that warpage and delamination of the light-modulation film can be suppressed.

The light-modulation element including the light-modulation film of the present invention can be applied to window panes of buildings and vehicles, shields for the purpose of protecting privacy, various kinds of decorations, lighting equipment, amusement tools and the like. Since a flexible substrate is used in the light-modulation film of the present invention, the light-modulation film is easily processed, and can be applied to a curved surface, resulting in excellent versatility.

EXAMPLES

Hereinafter, the present invention will be described more in detail by showing examples, but the present invention is not limited to the following examples.

[Example 1]

In Example 1, an Mg-Y light-modulation layer and a Pd catalyst layer were formed on a transparent film substrate using a roll-to-roll sputtering apparatus having two deposition chambers: a first deposition chamber including a first deposition roll and a second deposition chamber including a second deposition roll. An Mg-Y target was arranged so as to face the first deposition roll, and a Pd target was arranged so as to face the second deposition roll in the sputtering apparatus. An Mg-Y split target (manufactured by RARE METALLIC Co., Ltd.) having an Mg metal plate and a Y metal plate at an erosion portion area ratio of 2 : 5 was used as the Mg-Y target. A Pd metal target (manufactured by Tanaka Kikinzoku Kogyo) was used as the Pd target.

A roll body of a 188 $\mu$m-thick polyethylene terephthalate (PET) film (manufactured by Mitsubishi Plastics, Inc., heat shrinkage ratio in MD: 2%) was set in an unwinding roll of the sputtering apparatus, and each of the deposition chamber was evacuated until the ultimate vacuum degree reached $5 \times 10^{-3}$ Pa. The PET film substrate was conveyed in the sputtering apparatus without introducing a sputtering gas, the internal pressure of the first deposition chamber increased to $4 \times 10^{-2}$ Pa due to release of residual gas contained in the PET film.

Argon was introduced into each deposition chamber in the sputtering apparatus so that the process pressure was 0.4 Pa, a light-modulation layer (film thickness: 43 nm) composed of an Mg-Y alloy was deposited on the first deposition roll and a catalyst layer (thickness: 10 nm) composed of Pd was deposited on the second deposition roll in succession by DC sputtering while a PET film was unwound from an unwinding roll and conveyed at 3m/minute. The PET film was wound around a winding roll. Each of the substrate temperature during deposition of the light-modulation layer and the substrate temperature during deposition of the catalyst layer (temperature of the first deposition roll and the temperature of the second deposition roll) was -5°C, and the time (interval) required until formation of the catalyst layer on the light-modulation layer after deposition of the light-modulation layer was 5 minutes.

[Examples 2 and 3]

In Examples 2 and 3, a roll-to-roll sputtering apparatus identical to that in Example 1 was used, a Pd target was disposed so as to face the first deposition roll, an Mg-Y target was disposed so as to face the second deposition roll, and an Mg-Y light-modulation layer and a Pd catalyst layer were formed on a transparent film substrate. A roll body of a PET film having a thickness of 188 $\mu$m was set on the unwinding roll of the sputtering apparatus, and the PET film was fed from the unwinding roll and conveyed at 1 m/minute in the apparatus. Discharge from a cathode facing the first deposition roll was turned off, a light-modulation layer composed of an Mg-Y alloy was deposited by DC sputtering on the second deposition roll, and the film was wound around the winding roll. Thereafter, while the vacuum environment was maintained, discharge from the cathode facing the second deposition roll was turned off, discharge from the cathode facing the first deposition roll was started, the film was fed from the winding roll, a catalyst layer composed of a Pd layer was deposited by DC sputtering on the first deposition roll, and the film was wound around the unwinding roll. Each of the substrate temperature during deposition of the light-modulation layer and the substrate temperature during deposition of the catalyst layer was -5°C. The film substrate was sampled at two different points in the longitudinal direction, and the resulting samples were set to Examples 2 and 3, respectively. The interval between formation of the light-modulation layer and formation of the catalyst layer was 25 minutes in Example 2, and 60 minutes in Example 3.

[Comparative Example 1]

In Comparative Example 1, the same roll-to-roll sputtering apparatus as in Example 1 was used, and an Mg-Y light-modulation layer and a Pd catalyst layer were formed on a PET film using only a first deposition chamber. An Mg-Y target was arranged so as to face the first deposition roll, and a target was not arranged at a position facing a second deposition roll in the sputtering apparatus.

A roll body of a PET film having a thickness of 188 $\mu$m was set on the unwinding roll of the sputtering apparatus, and under the same conditions as in Example 1, the PET film was fed from the unwinding roll and conveyed in the apparatus, and a light-modulation layer composed of an Mg-Y alloy was simultaneously deposited by DC sputtering on the first deposition roll. The film was wound around a winding roll without performing deposition on the second deposition roll.

After depositing the Mg-Y alloy layer on the PET film, the vacuum was broken to expose the film to the air atmosphere and turn the inside of the sputtering apparatus to normal pressure, and the target disposed so as to face the first deposition roll was changed from the Mg-Y target to a Pd target. Thereafter, the PET film provided with the Mg-Y layer was fed from the winding roll side and conveyed in the apparatus, a Pd layer was simultaneously deposited by DC sputtering on the first deposition roll, and the film was wound around the unwinding roll. The substrate temperature during formation of the light-modulation layer and the catalyst layer was -5°C, and the interval between formation of the light-modulation layer and formation of the catalyst layer was 180 minutes (including the time for exposure to the air atmosphere).

[Measurement of oxygen content in light-modulation layer]

An oxygen concentration distribution in the light-modulation layer was determined by performing depth profile measurement using a scanning X-ray photoelectron spectrometer equipped with an Ar ion etching gun ("Quantum 2000" manufactured by ULVAC-PHI, Inc.). In analysis of the depth profile, a position which is situated between the catalyst layer and the light-modulation layer and at which the Pd element concentration is a half value of the maximum value of the Pd element concentration in the catalyst layer was defined as an interface between the catalyst layer and the light-modulation layer (start point of the light-modulation layer). The thickness (depth) in the depth profile was calculated by converting the etching time into the depth on the basis of the Ar ion etching rate of the silicon oxide layer. A maximum oxygen content within a range of 5 nm from an interface of the light-modulation layer and the catalyst layer was defined as an oxygen content in the light-modulation layer.

[Evaluation of light-modulation performance]

The light-modulation films of Examples and the Comparative Example were in a metallic luster reflective state. It was visually confirmed that the light-modulation films of Examples 1 to 3 turned to a transparent state when exposed to a hydrogen gas atmosphere at 1 atm with the hydrogen gas diluted to 1% by volume with argon, and thus light-modulation performance was confirmed. On the other hand, the light-modulation film of Comparative Example 1 did not turn into a transparent state even when exposed to a hydrogen gas atmosphere, and thus the light-modulation film did not have light-modulation performance. In Examples 1 and 2, the light-modulation film had higher transparency in a hydrogen gas atmosphere, and superior light-modulation property as compared to Example 3.

The conditions for manufacturing light-modulation films in Examples and Comparative Examples (whether or not the film is exposed to the air atmosphere until formation of the catalyst layer after formation of the light-modulation layer, and the interval), and the properties of the light-modulation films (the amount of oxygen in the light-modulation layer, and light-modulation property) are collectively shown in Table 1.

[Table 1]

| | Conditions until formation of catalyst layer after formation of light-modulation layer | | Properties of light-modulation film | |
| --- | --- | --- | --- | --- |
| | Exposure to air atmosphere | Interval | Amount of oxygen in light-modulation layer (%) | Light-modulation property |
| Example 1 | Not done | 5 minutes | 38 | very good |
| Example 2 | Not done | 25 minutes | 43 | very good |
| Example 3 | Not done | 60 minutes | 48 | good |
| Comparative Example 1 | Done | 180 minutes | 53 | poor |

The above-described results show that in Comparative Example 1 where the film was exposed to the air atmosphere after deposition of the light-modulation layer and before deposition of the catalyst layer, the light-modulation film did not have light-modulation property because the hydrogen absorption capacity of the light-modulation layer was reduced due to oxidation of the light-modulation layer. On the other hand, it is shown that in Examples 1 to 3, oxidation of the deposition surface of the light-modulation layer is suppressed to obtain a light-modulation film capable of switching between a transparent state and a reflective state can be obtained by hydrogenation and dehydrogenation because the catalyst layer is deposited without exposure to the air atmosphere after deposition of the light-modulation layer.

Comparison of Examples 1 to 3 shows that by reducing the time until on the deposition surface of the light-modulation layer, other layer (catalyst layer) is deposited, oxidation of the light-modulation layer is further suppressed, so that light-modulation property can be improved. It is apparent that for preparing a light-modulation film having uniform properties in the longitudinal direction by roll-to-roll sputtering, it is preferable that the time until deposition of the catalyst layer after deposition of the light-modulation layer is made constant in the longitudinal direction of the film substrate by depositing the light-modulation layer and the catalyst layer disposed thereon in one pass as in Example 1.

DESCRIPTION OF REFERENCE CHARACTERS

| | |
|---|---|
| 1, 2, 3 | light-modulation film |
| 10 | polymer film substrate |
| 30 | light-modulation layer |
| 31 | oxidized region |
| 32 | light-modulation region |
| 40 | catalyst layer |
| 20 | underlayer |
| 50 | buffer layer |
| 70 | surface layer |

**Claims**

1. A method for manufacturing a light-modulation film including: a light-modulation layer which reversibly changes in state between a transparent state by hydrogenation and a reflective state by dehydrogenation; and a catalyst layer which promotes hydrogenation and dehydrogenation in the light-modulation layer, in this order, on a polymer film substrate,
the method comprising:

   depositing the light-modulation layer and the catalyst layer on the film substrate by roll-to-roll sputtering; and continuously carrying out a process ranging from deposition of the light-modulation layer and deposition of the catalyst layer without exposure to the air atmosphere.

2. The method for manufacturing a light-modulation film according to claim 1, wherein a thin film of a metal selected from the group consisting of a rare earth metal, an alloy of a rare earth metal and magnesium, an alloy of alkaline earth metal and magnesium, and an alloy of a transition metal and magnesium is deposited as the light-modulation layer.

3. The method for manufacturing a light-modulation film according to claim 1 or 2, wherein an oxygen content of the light-modulation layer in a region within 5 nm from an interface on the catalyst layer side is less than 50 atom%.

4. The method for manufacturing a light-modulation film according to any one of claims 1 to 3, wherein the film substrate is unwound from an unwinding roll of a roll-to-roll sputtering apparatus, the film substrate is conveyed, and deposition of the light-modulation layer and deposition of the catalyst layer are carried out until the film substrate is wound around a winding roll.

FIG. 1

FIG. 2

FIG. 3

FIG. 4

FIG. 5

FIG. 6

## INTERNATIONAL SEARCH REPORT

International application No.

PCT/JP2017/011643

### A. CLASSIFICATION OF SUBJECT MATTER

*G02F1/19*(2006.01)i

According to International Patent Classification (IPC) or to both national classification and IPC

### B. FIELDS SEARCHED

Minimum documentation searched (classification system followed by classification symbols)
G02F1/19

Documentation searched other than minimum documentation to the extent that such documents are included in the fields searched
Jitsuyo Shinan Koho        1922–1996   Jitsuyo Shinan Toroku Koho   1996–2017
Kokai Jitsuyo Shinan Koho   1971–2017   Toroku Jitsuyo Shinan Koho   1994–2017

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2014-26262 A (National Institute of Advanced Industrial Science and Technology), 06 February 2014 (06.02.2014), paragraphs [0017] to [0127]; fig. 4 & US 2015/0168801 A1 paragraphs [0061] to [0176]; fig. 4 & WO 2013/191085 A1    & EP 2866085 A1 & KR 10-2015-0013849 A   & CN 104412154 A & ES 2578027 T | 1-4 |
| Y | Kazuki YOSHIMURA, "Switchable Mirror Window -Technology ni yori Kaiteki na Sho-energy Juseikatsu Kukan o Motomeru-", NanotechJapan Bulletin, 30 August 2013 (30.08.2013), vol.6, no.4 | 1-4 |

☒   Further documents are listed in the continuation of Box C.       ☐   See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18 May 2017 (18.05.17) | 06 June 2017 (06.06.17) |

| Name and mailing address of the ISA/ | Authorized officer |
|---|---|
| Japan Patent Office 3-4-3,Kasumigaseki,Chiyoda-ku, Tokyo 100-8915,Japan | |
| | Telephone No. |

Form PCT/ISA/210 (second sheet) (January 2015)

**INTERNATIONAL SEARCH REPORT**

International application No.

PCT/JP2017/011643

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2014-134676 A  (National Institute of Advanced Industrial Science and Technology), 24 July 2014 (24.07.2014), entire text; all drawings & US 2015/0354265 A1    & WO 2014/109182 A1 & KR 10-2015-0092299 A   & CN 104995555 A | 1-4 |
| A | US 2015/0198856 A1  (SAMSUNG ELECTRONICS CO., LTD.), 16 July 2015 (16.07.2015), entire text; all drawings & EP 2896991 A1          & KR 10-2015-0085213 A | 1-4 |

Form PCT/ISA/210 (continuation of second sheet) (January 2015)

17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013083911 A

- JP 2014026262 A